# EUROPÄISCHE PATENTSCHRIFT

(11) **EP 3 257 156 B1**
(45) Veröffentlichungstag und Bekanntmachung des Hinweises auf die Patenterteilung: **10.06.2020**
(21) Anmeldenummer: 16700592.5
(22) Anmeldetag: 14.01.2016
(51) Int. Cl.: H03K 5/05, H03K 5/06, H03K 5/156, H03K 5/26, H03K 5/00

(54) **VERFAHREN ZUM BETRIEB EINES IMPULSGENERATORS FÜR KAPAZITIVE SENSOREN UND IMPULSGENERATOR**
METHOD FOR OPERATING A PULSE GENERATOR FOR CAPACITIVE SENSORS, AND PULSE GENERATOR
PROCÉDÉ POUR LE FONCTIONNEMENT D'UN GÉNÉRATEUR D'IMPULSIONS POUR CAPTEURS CAPACITIFS ET GÉNÉRATEUR D'IMPULSIONS

(30) Priorität: 12.02.2015 DE 102015202510; 30.04.2015 DE 102015208060
(43) Veröffentlichungstag der Anmeldung: 20.12.2017
(73) Patentinhaber: IFM Electronic GmbH, 45128 Essen (DE)
(72) Erfinder: SCHULZ, Jörg, 88069 Tettnang (DE)
(86) Internationale Anmeldenummer: PCT/EP2016/050610
(87) Internationale Veröffentlichungsnummer: WO 2016/128164

(56) Entgegenhaltungen:
- EP-A1- 1 385 266
- EP-A1- 2 629 419
- US-B1- 6 452 514
- US-B1- 7 411 427

## Beschreibung

Die Erfindung betrifft ein Verfahren zum Betrieb eines Impulsgenerators für kapazitive Sensoren gemäß dem Oberbegriff des Patentanspruchs 1, sowie einen Impulsgenerator für einen kapazitiven Sensor.

Darüber hinaus wird eine sogenannte Front-Schaltung für einen kapazitiven Sensor mit dem erfindungsgemäßen Impulsgenerator angegeben.

Kapazitive Sensoren sind nicht nur in der Automatisierungstechnik, sondern neuerdings auch in der Automobiltechnik weit verbreitet, wo sie u. a. als Kofferraum-, Türöffner, oder zur Sitzbelegungserkennung Anwendung finden.

Sie weisen mindestens eine von außen beeinflussbare Elektrodenkapazität auf, deren Elektroden mit einem hochfrequenten Wechselstrom beaufschlagt werden. Die von einem in das elektrische Wechselfeld eintauchenden Objekt hervorgerufenen Kapazitätsänderungen werden zur besseren Weiterverarbeitung meist in einen Impuls mit variabler Länge umgewandelt. Geräte dieser Art werden auch von der Anmelderin hergestellt und vertrieben.

Um Fehlschaltungen zu vermeiden, werden mehrere Elektroden verwendet, die eine genauere Analyse der Situation ermöglichen. Beispielsweise müssen Regen, Schnee oder fallende Blätter oder auch unbeabsichtigte menschliche Beeinflussungen wie z.B. Vorbeigehen sicher von einer sich in definierter Weise nähernden Hand oder einem Fuß unterschieden werden.

Eine solche kapazitive Sensoranordnung mit einem Ladungsimpulsausgang wird in der Literatur auch als Front-end-Elektronik bezeichnet.

Zu ihrem Betrieb benötigt sie einen Impulsgenerator zur Erzeugung von kurzen elektrischen Impulsen. Ein geeigneter Impulsgenerator wird in der DE 103 59 441 A1 gezeigt.

Hierbei ist allerdings die Impulsdauer nicht einstellbar, was nachteilig bei der Realisierung von verschiedenen Messaufgaben mit unterschiedlichen Impulslängen ist.

Außerdem ist diese Schaltung nicht zur Ansteuerung von digitalen Baugruppen geeignet, was ebenfalls als Nachteil angesehen wird.

Eine Schaltung zur Einstellung der Impulsbreite des Taktsignals für einen Mikroprozessor mit der Bezeichnung "impulse width timing circuit" wird in der US 2011 / 0 080 201 A1 gezeigt. Hier wird ein rechteckförmiges Eingangssignal zwei komplementären RC-Gliedern zugeführt. Komplementär bedeutet hier, dass eine Kapazität durch einen ersten Widerstandspfad schnell und durch einen zweiten entgegengesetzt wirkenden Widerstandspfad langsam umgeladen werden kann. In der oben genannten Schrift wird eine variable Verzögerungszeit durch eine variable Kapazität und eine Impulsdauer durch variable Kapazitäten und/oder Widerstände eingestellt. Als nachteilig werden die abstimmbaren Widerstände und Kapazitäten angesehen. Die US 7 411 427 B1 beschreibt einen Impulsgenerator mit einer programmierbaren Verzögerungsschaltung (programmable low pass delay) mit geschalteten Kondensatoren (34-41). Die Kondensatoren sind Bestandteil eines im Signalweg befindlichen Tiefpasses und werden von jeweils einem Schalter zugeschaltet oder vom Signalweg getrennt.

Als nachteilig wird der hohe Aufwand angesehen, weil pro Bit ein Kondensator und ein Schaltelement mit einem Transistorpaar erforderlich ist.

Die EP 1 385 266 A1 beschreibt einen Mikrowellen-Pulsgenerator mit einem Resonanzkreis und einer Impulsverkürzungsstufe. Die Impulsverkürzung erfolgt mit einer als spannungsgesteuerte Kapazität wirkenden Kapazitätsdiode. Ein derartiger Aufwand wird als zu hoch. Die Aufgabe der Erfindung besteht darin, ein Verfahren zur Erzeugung variabler Impulse für kapazitive Sensoren, sowie einen universell für verschiedene Messaufgaben einsetzbaren Impulsgenerator mit einstellbarer Impulszeit anzugeben, die diese Nachteile vermeiden Insbesondere soll auf variable Widerstände und Kapazitäten verzichtet werden. Außerdem soll der Impulsgenerator auch zur Ansteuerung digitaler Baugruppen geeignet sein. Diese Aufgabe wird entsprechend dem Kennzeichen des Patentanspruchs 1 gelöst. Der Anspruch 2 betrifft einen erfindungsgemäßen Impulsgenerator. Die Unteransprüche betreffen die vorteilhafte Ausgestaltung der Erfindung.

Der wesentliche Erfindungsgedanke besteht darin, ein Taktsignal zu generieren, und dieses Taktsignal auf zwei verschiedenen Signalpfaden T1, T2 einem logischen Verknüpfungsglied 3 zuzuführen, wobei der erste Signalpfad T1 das Taktsignal nicht merklich verzögert, und der zweite Signalpfad T2 eine Verzögerungsschaltung 2 enthält. wird. Die Verzögerungsschaltung 2 weist ein erstes integrierendes RC-Glied mit einer kurzen Verzögerungszeitkonstanten RT1, CT1 im Zeitbereich zwischen 10ns und 200ns auf. Außerdem weist die Verzögerungsschaltung 2 ein zweites integrierendes RC-Glied mit einer zweiten, längeren Vorladezeitkonstanten RT2, CT2 mit einem Wert von größer als 1µs auf. Dieses RC-Glied wird mit einem Vorladesignal VL vorgeladen, um dadurch eine steuerbare Vorspannung zu erzeugen, wodurch die resultierende Impulsdauer zeitlich steuerbar wird. Die Verzögerungsschaltung wird an ihrem Ausgang zur Wiederherstellung eines definierten Initialzustandes zyklisch durch einen Initialisierungsschalter S1 entladen bzw. aufgeladen. Das logische Verknüpfungsglied 3 weist zwei Eingänge und einen Ausgang LVA auf, an dem der zu generierende Impuls auftritt.

Somit ist der erfindungsgemäße Impulsgenerator für eine so genannte Front-Schaltung zur kapazitiven Erfassung des Abstandes, der Geschwindigkeit oder der Position eines Objekts geeignet. Diese weist mindestens zwei auch miteinander gekoppelte Elektrodenkapazitäten auf, deren Ladung in bekannter Weise auf einen Ladungsimpulsausgang übertragen wird.

Im Kraftfahrzeug kann das ein Sitzbelegungssensor, ein kapazitiver Türöffner oder auch ein Heckklappenöffner sein.

Die Messwerte können zur Erzeugung eines binären Schaltsignals oder zur Erzeugung von binären oder analogen Diagnosesignalen verwendet werden, die über eine Busschnittstelle übertagbar sind.

Die Erfindung wird anhand der Zeichnung näher erläutert.

Die Fig. 1 zeigt einen Impulsgenerator 1 gemäß einer Ausführungsform der Erfindung.

Die Fig. 2 zeigt eine Front-Schaltung für einen kapazitiven Sensor mit dem erfindungsgemäßen Impulsgenerator.

Die Fig. 3 bis 10 zeigen Impulsgeneratoren, die zur Durchführung des erfindungsgemäßen Verfahrens geeignet sind.

Die Fig. 11 zeigt das Impulsdiagramm des in Fig. 1 gezeigten Impulsgenerators 1.

Ein Impulsgenerator 1 gemäß einer Ausführungsform der Erfindung weist folgende Merkmale bzw. Komponenten auf:
- Eine Takterzeugungseinheit, die zwei zeitgleiche Taktsignale erzeugt
- ein logisches Verknüpfungsglied 3 mit zwei Eingängen und einem Ausgang
- der erste Taktsignaleingang ist mit dem ersten Eingang des logischen Verknüpfungsgliedes 3 verbunden,
- der zweite Taktsignaleingang ist mit einem ersten Eingang einer Verzögerungsschaltung verbunden,
- die Verzögerungsschaltung enthält folgende Unterbaugruppen:
   ∘ ein erstes RC-Glied mit einer ersten, kürzeren, integrierenden Verzögerungszeitkonstante RT1, CT1 im Zeitbereich 10ns bis 200ns
   ∘ ein zweites RC-Glied mit einer zweiten, größeren, integrierenden Vorladezeitkonstante RT2, CT2 im Zeitbereich größer 1µs, welches über ein einstellbares Vorladesignal VL vorgeladen wird
- der Ausgang der Verzögerungsschaltung 2 ist mit dem zweiten Eingang des logischen Verknüpfungsgliedes 3 verbunden,
- der zweite Eingang des logischen Verknüpfungsgliedes 3 ist für den Betrieb als Schwellwertschalter ausgelegt
- der Ausgang des logischen Verknüpfungsgliedes 3 ist mit dem entsprechenden Steuereinganges der kapazitiven Sensorschaltung verbunden.
- ein Initialisierungsschalter S1 zur zyklischen Wiederherstellung eines definierten Initialzustandes
- Eine Steuereinheit 4 (Mikrokontroller), die folgende Ausgangssignale zur Verfügung stellt:
   ∘ mindestens ein Taktsignal, welches mit dem Eingang T1 verbunden ist
   ∘ optional ein weiteres Taktsignal, welches mit dem Eingang T2 verbunden ist
   ∘ ein Vorladesignal, welches mit dem Eingang VL der Verzögerungsschaltung verbunden ist
   ∘ ein Steuersignal IS für den Initialisierungsschalter, welches mit dem Steuereingang des Initialisierungsschalters verbunden ist,
   ∘ optional ein Steuersignal IP, welches das Spannungspotenzial des Initialisierungsschalters vorgibt.

Das zweite Taktsignal kann direkt durch die Steuereinheit 4 oder wahlweise auch durch einfache logische Invertierung des ersten Taktsignals erzeugt werden. Die prinzipielle Wirkungsweise des erfindungsgemäßen Impulsgenerators 1 ändert sich dadurch nicht.

Der Initialisierungsschalter S1, auch mit 5 bezeichnet, kann als diskretes Bauteil ausgeführt sein, z.B. ein Analogschalter oder ein Schalttransistor, oder auch intern in der Steuereinheit integriert sein. In diesem Fall wird das Steuersignal für den Initialisierungsschalter S1 auch nur intern in der Steuereinheit 4 erzeugt. In den folgenden Figuren ist dieser Schalter dennoch als Bauteil dargestellt, um die Funktion zu veranschaulichen.

Die eingestellte Wirkungsrichtung des Initialisierungsschalters S1, gegen Masse oder gegen Betriebsspannung, hängt von der konkreten Ausgestaltung des Impulsgenerators 1 ab, das heißt in Abhängigkeit davon, ob ein UND-Gatter, ein NAND-Gatter, ein NOR-Gatter, ein EXOR-Gatter oder eine komplexere logische Funktion für das logische Verknüpfungsglied ausgewählt wird, ist der logische Zustand verschieden, der das gewünschte Verhalten in Abhängigkeit von den anderen Steuersignalen erzeugt. Durch variable Steuerung des Eingangs IP können sogar unter Verwendung eines geeigneten Gattertyps sowohl positive als auch negative Ausgangsimpulse erzeugt werden.

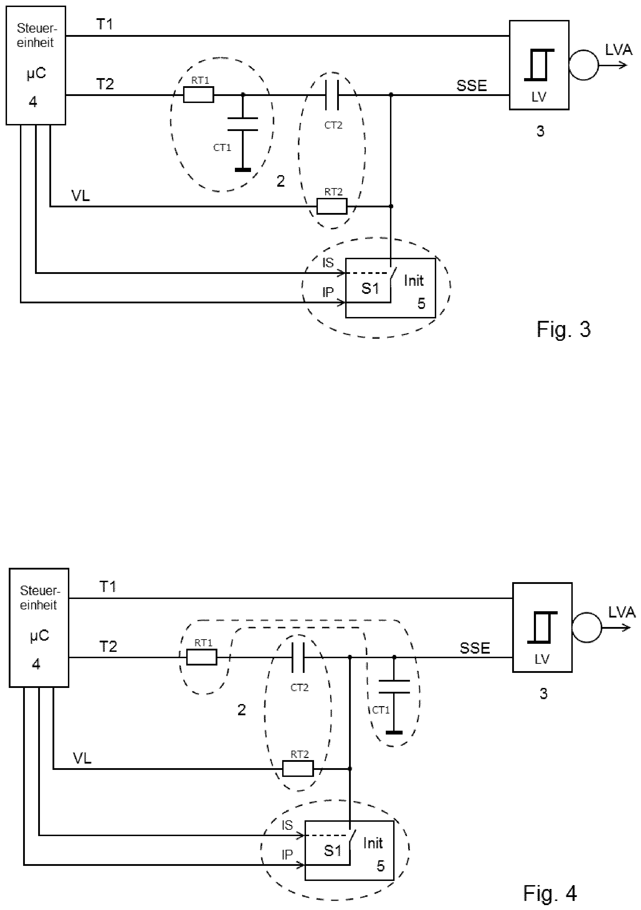

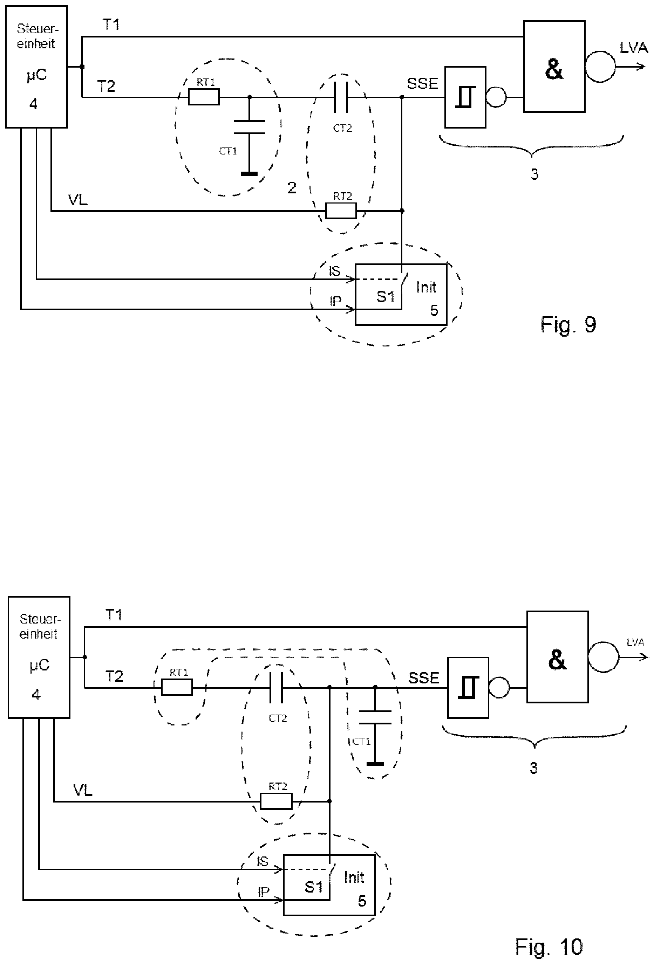

In den folgenden Ausführungsbeispielen ist die Auswahl jedoch beschränkt auf die Verwendung eines logischen Verknüpfungsgliedes vom Typ NAND-Schmitt-Trigger in den Fig. 3 bis 8 oder auf einen zusammengesetzten Typ aus NAND-Gatter und Schmitt-Trigger an einem Eingang des NAND-Gatters in den Fig. 9 und 10.

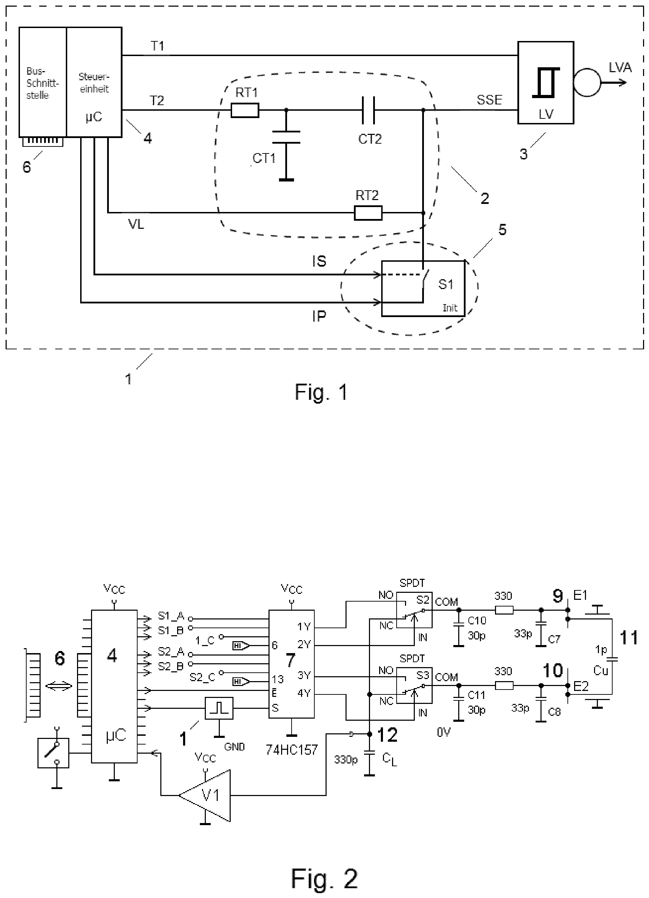

Die Bauteile des ersten RC-Gliedes RT1, CT1, die miteinander eine Verzögerungszeitkonstante bilden, können direkt hintereinander angeordnet sein, wie in Fig.1, Fig. 3, Fig.5, Fig.7, Fig.9 dargestellt.

Die Bauteile RT1, CT1 können aber auch in einer weiteren, bevorzugten Ausführung so angeordnet sein, dass sie funktionell eine Verzögerungszeitkonstante bilden, ohne dass sie direkt konstruktiv miteinander verbunden sind, wie in Fig. 4, Fig.6, Fig.8, Fig.10 dargestellt. Bei genauerer Betrachtung entsteht hier natürlich für die Verzögerungszeitkonstante eine Reihenschaltung aus CT2 und CT1. Wenn die Kapazität von CT2 jedoch wesentlich größer ist als die Kapazität von CT1, dann unterscheiden sich beide Ausführungsvarianten in der Wirkung kaum voneinander, so dass RT1, CT1 immer noch die im Wesentlichen bestimmenden Bauteile für die Verzögerungszeitkonstante sind.

Für die Vorladezeitkonstante RT2, CT2 ergibt sich in Fig. 4, Fig.6, Fig.8, Fig.10 bei genauer Betrachtung eine Parallelschaltung aus CT2 und CT1. Wenn die Kapazität von CT2 jedoch wesentlich größer ist als die Kapazität von CT1, dann unterscheiden sich beide Ausführungsvarianten in der Wirkung kaum voneinander, so dass RT2, CT2 immer noch die im Wesentlichen bestimmenden Bauteile für die Vorladezeitkonstante sind.

Die Vorteile der bevorzugten Ausführungsbeispiele in Fig. 4, Fig.6, Fig.8, Fig.10 ergeben sich aus den relativ kurzen beabsichtigten Impulszeiten und den dafür benötigten kurzen Verzögerungszeitkonstanten für RT1, CT1, welche im Bereich weniger Nanosekunden liegen können. Daraus ergeben sich mit zuverlässig anwendbaren Widerstandswerten für RT1 im Bereich von einigen Kiloohm relativ kleine Kapazitätswerte im Bereich weniger Pikofarad, die bereits durch parasitäre Eingangskapazitäten entstehen können und deshalb schlecht definierbar sind. Somit ist es nur von Vorteil, wenn die erforderlichen einzelnen Kapazitätswerte zur Realisierung der gewünschten Verzögerungszeitkonstante durch die Reihenschaltung von CT1 und CT2 tendenziell etwas größer dimensioniert werden können.

Außerdem sind die parasitären Eingangskapazitäten des logischen Verknüpfungsgliedes und des Entladeschalters sowieso unvermeidbar parallel zu CT1 vorhanden, was bei sehr kurzen Verzögerungszeiten sogar den Kondensator CT1 überflüssig machen kann, so dass die Funktion von CT1 bereits durch die parasitären Kapazitäten realisiert ist. Dies ist besonders kostengünstig.

Weitere Aspekte zur Auswahl der beiden Anordnungsvarianten gemäß Fig.1, Fig. 3, Fig.5, Fig.7, Fig.9 oder gemäß in Fig. 4, Fig.6, Fig.8, Fig.10 kann der Fachmann mit Erfahrung im Bereich der Analog- und Digitaltechnik sowie auf dem Gebiet der EMV selbst erarbeiten.

Die in Fig. 2 gezeigte Schaltung dient dazu, die mit 9 und 10 bezeichneten Kapazitäten der Elektroden E1 und E2 gegen Masse zu bestimmen. Der Kondensator Cu repräsentiert die gegenseitige Kapazität 11 der beiden Elektroden. Selbstverständlich können noch weitere Messelektroden vorhanden sein.

Die Ladungen werden in Impulse mit variabler Ladungsmenge umgewandelt und auf einen größeren und leichter auswertbaren, auch als Ladungsausgang 12 bezeichneten Kondensator CL übertragen.

Die beiden Elektrodenkapazitäten 9 und 10 enthalten weiterhin Kondensatoren C7, bzw. C8, die über hier vereinfacht dargestellte 330Ω-Widerstände (sinnvoller Bereich: 50Ω ... 1kΩ), mit den Kondensatoren C10, bzw. C11 verbunden sind.

Die Elektrodenkapazitäten 9 und 10 können über zwei Analogschalter S2 und S3 mit dem Ladekondensator CL des Ladungsimpulsausgangs 12 oder den Ausgängen des Multiplexers 7 (74HC157) verbunden werden.

Der Multiplexer 7 wird von dem einzigen Impulsgenerator 1 mit den erforderlichen Messimpulsen versorgt. Der Impulsgenerator 1 und der Multiplexer 7 werden von einer Steuer- und Auswerteeinheit 4, gesteuert, die vorteilhaft als Mikrocontroller ausgeführt ist. Die Analogschalter S2 und S3 können z. B. in einer integrierten Schaltung 74LVC1G53 untergebracht sein. Der Multiplexer 7 kann beispielsweise ein IC 74(A)HC157 sein. So können die beiden Elektroden E1 und E2 gleichphasig oder gegenphasig gesteuert und ausgewertet werden. Die daraus resultierenden Ergebnisse können als binäre Schalt- oder Diagnosesignale oder als andere analoge oder digitale "Entscheidungssignale", beispielsweise auch über eine Busschnittstelle 6, ausgegeben werden.

Die in der Fig. 2 gezeigte Schaltung ist besonders als Türöffner für Kraftfahrzeuge, z. B. auch als Kofferraum- oder Heckklappenöffner geeignet.

Die Fig. 3 zeigt einen Impulsgenerator 1 gemäß einer Ausführungsform der Erfindung mit einstellbarer Impulsdauer als Teil der in Fig. 2 gezeigten Front-Schaltung für einen kapazitiven Sensor.

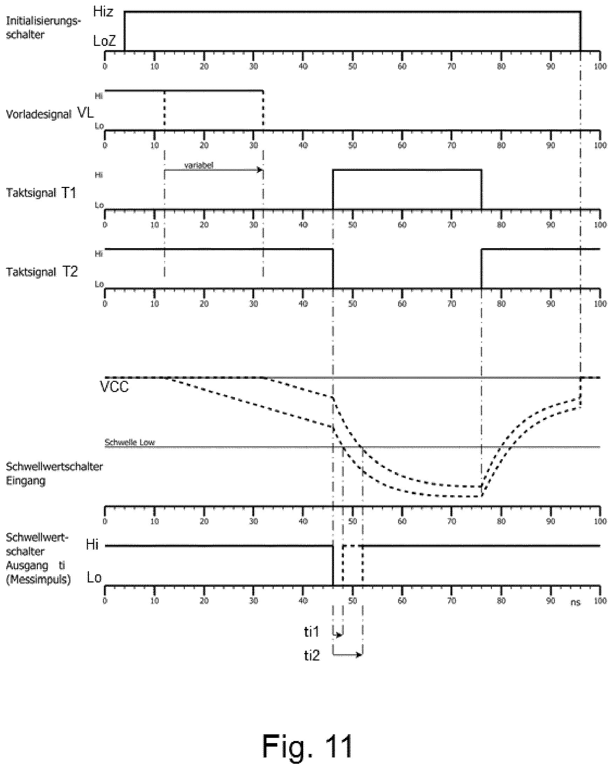

Der Impulsgenerator 1 dient zur Erzeugung von Messimpulsen im Zeitbereich von 10ns bis 200ns für die o. g. Schaltung. Die Impulsdauer ti1, ti2 der Messimpulse, wie in Fig. 11 dargestellt, kann von der Steuer- und Auswerteeinheit 7 variabel eingestellt werden. Hierzu sind zwei Taktsignale, ein zeitlich einstellbares Vorladesignal und ein Steuersignal für den Initialisierungsschalter erforderlich. Die Vorladezeit liegt im Bereich von 0...20 µs.

Der Vorteil der Schaltung besteht darin, dass die o. g. Takt- und Steuersignale mit einem handelsüblichen Mikrocontroller mit einer Taktfrequenz unter 20 MHz noch präzise erzeugt werden können.

Das erste Taktsignal T1, welches von der Steuer- und Auswerteeinheit 4 erzeugt wird, wird auf einen ersten Eingang des logischen Verknüpfungsgliedes 3 geführt. Das zweite, in diesem Fall gegenphasige Taktsignal T2 liegt am Eingang einer Verzögerungsschaltung 2 an und wird im Wesentlichen durch die Zeitkonstante RT1, CT1 in eine integrierende E-Funktion umgewandelt, welche am Ausgang der Verzögerungsschaltung 2 erscheint und von dort auf den zweiten Eingang des logischen Verknüpfungsgliedes 3 geführt wird. Die Verzögerungsschaltung 2 weist eine weitere, größere Zeitkonstante RT2, CT2 auf, wobei der Kondensator CT2 über den Widerstand RT2 und den Vorladeeingang VL mit einem zeitlich variablen Vorladesignal beaufschlagt wird.

Die Messimpulse werden am Ausgang LVA des logischen Verknüpfungsgliedes 3 erzeugt. Da die zweite Zeitkonstante RT2, CT2 größer ist als die erste Zeitkonstante CT1, RT1, wird durch diesen zweiten, langsameren Ladevorgang eine einstellbare Vorspannung für den zweiten Eingang des logischen Verknüpfungsgliedes 3 erzeugt.

Der ebenfalls von der Steuer- und Auswerteeinheit 4 gesteuerte Initialisierungsschalter 5 sorgt im Zustand "LoZ" nach jedem Messimpuls, der am Ausgang LVA des logischen

Verknüpfungsgliedes 3 entsteht, zyklisch für die Entladung bzw. Aufladung der Verzögerungsschaltung.

Die Fig. 4 zeigt die Grundschaltung aus Fig.3, jedoch mit bevorzugter, alternativer Anordnung von CT1.

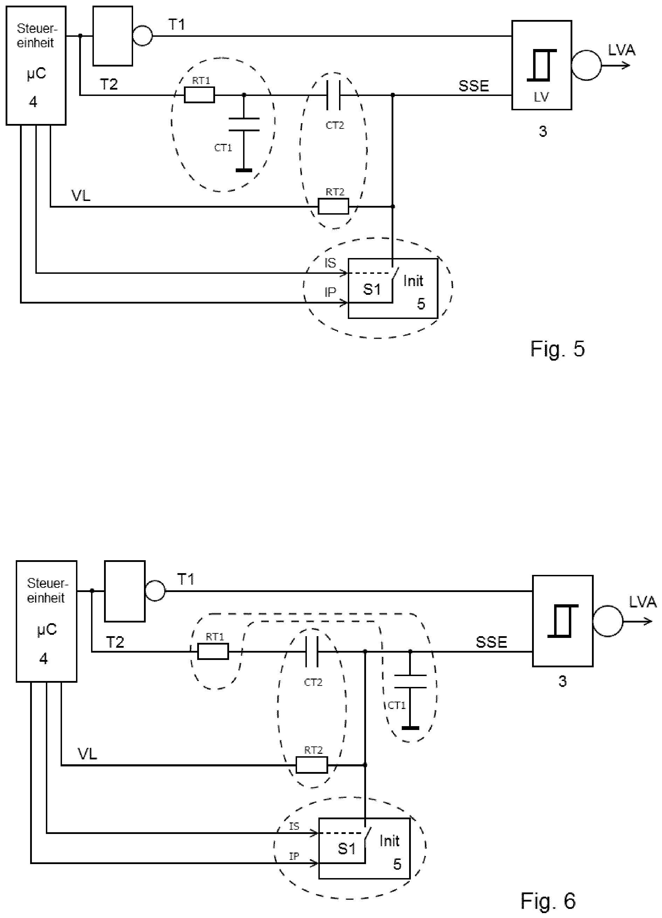

Die Fig. 5 zeigt einen Impulsgenerator 1 gemäß einer Ausführungsform der Erfindung mit nur einem einzigen von der Steuereinheit erzeugten Taktsignal T2, während das zweite, in diesem Fall gegenphasig benötigte Taktsignal T1 durch Invertierung mit einem Intervierungsglied gewonnen wird Die Fig. 6 zeigt die Grundschaltung aus Fig. 5, jedoch mit bevorzugter, alternativer Anordnung von CT1.

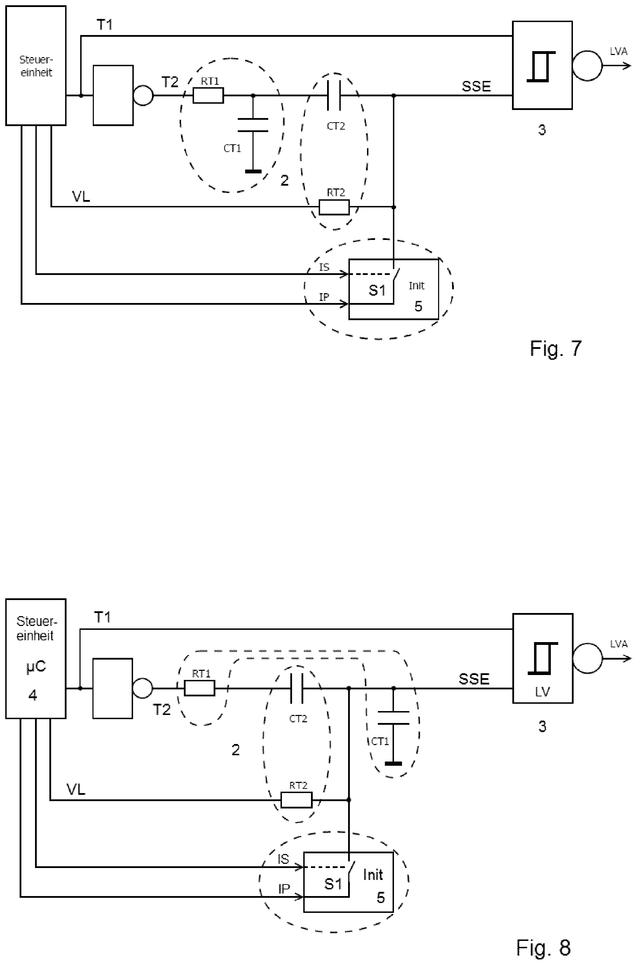

Die Fig. 7 zeigt einen Impulsgenerator 1 gemäß einer Ausführungsform der Erfindung, wobei das der Verzögerungsschaltung 2 zugeführte Signal invertiert wird (T2), während das unverzögerte Taktsignal T1 von der Steuereinheit erzeugt wird und direkt auf den Eingang des logischen Verknüpfungsgliedes 3 geführt wird.

Die Fig. 8 zeigt die Grundschaltung aus Fig. 7, jedoch mit bevorzugter, alternativer Anordnung von CT1.

Die Fig. 9 zeigt einen Impulsgenerator 1 gemäß einer Ausführungsform der Erfindung, bei dem zwei gleichphasige Taktsignale T1 und T2 verwendet werden, wobei die logische Funktion des Verknüpfungsgliedes 3 in diesem Fall einen invertierten Eingang aufweist, realisiert durch einen invertierenden Schmitt-Trigger.

Die Fig. 10 zeigt die Grundschaltung aus Fig. 8, jedoch mit bevorzugter, alternativer Anordnung von CT1.

Die Fig. 11 zeigt das Impulsdiagramm des in Fig. 1 und in Fig. 3 gezeigten Impulsgenerators 1.

Vor jedem neuen Impuls wird die Verzögerungsschaltung durch den Initialisierungsschalter 5 entladen bzw. aufgeladen, dessen Ausgangszustand (LoZ=niederohmig, HiZ=hochohmig) in der obersten Signalzeile als Funktion der Zeit dargestellt ist.

In der zweiten, darunter liegenden Signalzeile ist das Vorladesignal VL dargestellt, mit dem die Verzögerungsschaltung vorgeladen wird. Das Vorladesignal kann variabel sein.

Dargestellt sind zwei unterschiedlich lange Vorladesignale, die erfindungsgemäß eine unterschiedliche Vorspannung am Ausgang der Verzögerungsschaltung beziehungsweise am Knoten SSE des Schwellwertschalter-Einganges des logischen Verknüpfungsgliedes 3 erzeugen.

Mit der positiven Flanke des ersten Taktsignals T1, welches in der dritten Signalzeile des Diagramms als "Taktsignal T1" dargestellt ist, schaltet der Ausgang LVA des logischen Verknüpfungsgliedes 3 von "High" auf "Low" was in der sechsten Signalzeile mit "Schwellwertschalter Ausgang ti" dargestellt ist. Gleichzeitig startet das zweite Taktsignal T2, welches in der vierten Signalzeile des Diagramms als "Taktsignal T2" dargestellt ist, über RT1 eine Entladung von CT1, welche in der fünften Signalzeile dargestellt ist. Abhängig von der Verzögerungszeitkonstante RT1, CT1 kommt es am Knoten SSE des Schwellwertschalter-Einganges des logischen Verknüpfungsgliedes 3 zur Unterschreitung einer mit "Schwelle Low" bezeichneten Schaltschwelle des logischen Verknüpfungsgliedes 3, welches daraufhin, wie in der sechsten Signalzeile dargestellt, seinen Ausgangszustand wieder von Low auf High ändert.

Durch das variable Vorladesignal VL erhält die Verzögerungsschaltung am Knoten SSE eine variable Vorspannung, wodurch der Zeitpunkt der Schaltschwellenunterschreitung ebenfalls variiert und dadurch die gewünschte, variable Impulsdauer, generiert wird. Wie man anhand der beiden dargestellten Beispiele mit unterschiedlicher Vorladung erkennt, führt die Anhebung oder Absenkung des näherungsweise exponentiell verlaufenden Entladevorgangs von CT1 zu unterschiedlichen Impulslängen, hier durch die beiden Zeiten ti1 und ti2 dargestellt. Anschließend wird der Ausgang der Verzögerungsschaltung zur erneuten Herstellung eines definierten Initialzustandes durch den Initialisierungsschalter 5 wieder aufgeladen.

Gemäß einer Ausführungsform der Erfindung besteht das Verfahren zum Betrieb des Impulsgenerators 1 darin, dass
- Zwei zeitgleiche Taktsignale T1, T2 erzeugt werden,
- das erste Taktsignal T1 den ersten Eingang eines logischen Verknüpfungsgliedes 3 ansteuert,
- der zweite Taktsignaleingang T2 den ersten Eingang einer Verzögerungsschaltung ansteuert,
- die Verzögerungsschaltung das zweite Taktsignal abhängig von einer integrierenden Verzögerungszeitkonstante RT1, CT1 in ein analoges Ausgangssignal umwandelt und dadurch eine Zeitverzögerung im Zeitbereich 10ns bis 200ns erzeugt,
- dieser Ausgang der Verzögerungsschaltung auf den zweiten Eingang des logischen Verknüpfungsgliedes 3 geführt wird, welcher als Schwellwertschalter arbeitet,
- die Verzögerungsschaltung an einem zweiten Eingang ein zeitvariables Vorladesignal VL aufnimmt, welches über eine integrierende Vorladezeitkonstante RT2, CT2 im Zeitbereich größer 1µs und dass die Verzögerungsschaltung über ein einstellbares Vorladesignal vorgeladen wird,
- der Ausgang LVA des logischen Verknüpfungsgliedes 3 den entsprechenden Steuereinganges der kapazitiven Sensorschaltung mit einer variablen Impulsdauer ansteuert,
- ein Initialisierungsschalter den Ausgang der Verzögerungsschaltung 2 zur zyklischen Wiederherstellung eines definierten Initialzustandes auflädt bzw. entlädt,
- eine Steuereinheit (Mikrokontroller) 4, folgende Ausgangssignale zur Verfügung stellt:
   ∘ mindestens ein erstes Taktsignal Takt_1, bzw. T1
   ∘ optional ein weiteres Taktsignal Takt_2, bzw. T2
   ∘ ein zeitvariables Vorladesignal VL, welches den Vorladeeingang der Verzögerungsschaltung 2 ansteuert
   ∘ ein Steuersignal IS, welches den Steuereingang des Initialisierungsschalters S1 ansteuert,
   ∘ optional ein Steuersignal IP, welches das Spannungspotenzial des Initialisierungsschalters 5 (S1) 1 vorgibt.

### Bezugszeichenliste

- 1: Impulsgenerator zur Erzeugung von Messimpulsen
- 2: Steuerbare Verzögerungsschaltung mit RC-Kombinationen RT1, CT1, RT2, CT2
- 3: Logisches Verknüpfungsglied, z. B, NAND-Gatter mit einem Triggereingang
- 4: Steuer- und Auswerteeinheit, (Mikrocontroller)
- 5: Initialisierungsschalter, S1
- 6: Busschnittstelle
- 7: Multiplexer
- 9: Kapazität der Mess-Elektrode E1
- 10: Kapazität der Mess-Elektrode E2
- 11: Gegenseitige Kapazität der Messelektroden
- 12: Ladungsimpulsausgang

## Patentansprüche

1. Verfahren zum Betrieb eines Impulsgenerators (1) zur Erzeugung von Messimpulsen für einen kapazitiven Sensor mit einstellbarer Impulszeit im Bereich von 10ns bis 200ns mit einer steuerbaren Verzögerungsschaltung (2), die eine erste integrierende RC-Kombination (RT1/CT1) und eine zweite integrierende RC-Kombination (RT2/CT2) enthält, mit einem logischen Verknüpfungsglied (3) mit zwei Eingängen und einem Ausgang, einem Initialisierungsschalter (5) und einer Steuereinheit (4), wobei der erste Eingang des logischen Verknüpfungsgliedes (3) ein Taktsignal, und dessen zweiter Eingang ein analoges Einstellsignal (SSE) vom Ausgang der Verzögerungsschaltung (2) erhält, wobei ein Taktsignal generiert und auf zwei verschiedenen Signalpfaden (T1, T2) dem logischen Verknüpfungsglied (3) zugeführt wird, wobei der erste Signalpfad (T1) das Taktsignal nicht merklich verzögert, und der zweite Signalpfad (T2) die Verzögerungsschaltung (2) enthält, das Taktsignal (T1) auf den ersten Eingang des logischen Verknüpfungsgliedes (3), und das durch den zweiten Signalpfad verzögerte Taktsignal (T2) auf den zweiten Eingang des logischen Verknüpfungsgliedes (3) geführt wird, wobei der Ausgang der Verzögerungsschaltung (2) nach jedem Messimpuls durch den Initialisierungsschalter (5) entladen oder aufgeladen wird, **dadurch gekennzeichnet, dass** die Verzögerungsschaltung (2) durch ein variables Vorladesignal (VL) eine variable Vorspannung an dem Ausgang (SSE) der Verzögerungsschaltung erhält, wodurch der Zeitpunkt der Unterschreitung einer Schaltschwelle des logischen Verknüpfungsgliedes variiert, und zeitvariable Ausgangsimpulse mit Hilfe von zeitvariablen Vorladesignalen (VL) erzeugt werden.

2. Impulsgenerator (1) zur Durchführung des Verfahrens nach Anspruch 1.

3. Impulsgenerator (1) nach Anspruch 2, **dadurch gekennzeichnet, dass** die Zeitkonstante der ersten integrierenden RC-Kombination (RT1/CT1) im Zeitbereich zwischen 10ns und 200ns liegt, und die Zeitkonstante der zweiten integrierenden RC-Kombination (RT2/CT2) einem Wert größer als 1µs aufweist.

4. Verwendung eines Impulsgenerators (1) nach Anspruch 2 oder 3 in einem kapazitiven Sensor, wobei die Steuereinheit (4) zur Auswertung der Messsignale und zur Ausgabe eines binären Schaltsignals und /oder eines Diagnosesignals dient.

5. Verwendung eines Impulsgenerators (1) nach Anspruch 2 oder 3 in einem kapazitiven Sensor, wobei die Steuereinheit (4) zur Auswertung der Messsignale und zur Ausgabe eines binären Schaltsignals und /oder eines Diagnosesignals über eine Busschnittstelle (6) dient.

6. Verwendung eines Impulsgenerators 1 nach Anspruch 2 oder 3 für einen kapazitiven Sensor in einem Kraftfahrzeug z. B. für einen Türöffner oder eine Kofferraumklappe.

## Claims

1. Method for operating a pulse generator (1) for generating measurement pulses for a capacitive sensor with an adjustable pulse time in the range of 10 ns to 200 ns, having a controllable delay circuit (2) which contains a first integrating RC combination (RT1/CT1) and a second integrating RC combination (RT2/CT2), having a logical combination element (3) with two inputs and an output, having an initialization switch (5) and having a control unit (4), wherein the first input of the logical combination element (3) receives a clock signal and its second input receives an analogue adjustment signal (SSE) from the output of the delay circuit (2), wherein a clock signal is generated and is supplied to the logical combination element (3) on two different signal paths (T1, T2), wherein the first signal path (T1) does not noticeably delay the clock signal and the second signal path (T2) contains the delay circuit (2), the clock signal (T1) is passed to the first input of the logical combination element (3) and the clock signal (T2) delayed by the second signal path is passed to the second input of the logical combination element (3), wherein the output of the delay circuit (2) is discharged or charged by the initialization switch (5) after each measurement pulse, **characterized in that** the delay circuit (2) receives a variable bias voltage at the output (SSE) of the delay circuit by means of a variable precharge signal (VL), as a result of which the time at which a switching threshold of the logical combination element is undershot varies, and time-variable output pulses are generated with the aid of time-variable precharge signals (VL).

2. Pulse generator (1) for carrying out the method according to Claim 1.

3. Pulse generator (1) according to Claim 2, **characterized in that** the time constant of the first integrating RC combination (RT1/CT1) is in the time range between 10 ns and 200 ns, and the time constant of the second integrating RC combination (RT2/CT2) has a value of greater than 1 µs.

4. Use of a pulse generator (1) according to Claim 2 or 3 in a capacitive sensor, wherein the control unit (4) is used to evaluate the measurement signals and to output a binary switching signal and/or a diagnostic signal.

5. Use of a pulse generator (1) according to Claim 2 or 3 in a capacitive sensor, wherein the control unit (4) is used to evaluate the measurement signals and to output a binary switching signal and/or a diagnostic signal via a bus interface (6).

6. Use of a pulse generator (1) according to Claim 2 or 3 for a capacitive sensor in a motor vehicle, for example for a door opener or a boot lid.

## Revendications

1. Procédé pour le fonctionnement d'un générateur d'impulsions (1) pour générer des impulsions de mesure pour un capteur capacitif présentant un temps d'impulsion réglable dans la plage de 10 ns à 200 ns, comprenant un circuit de retardement (2) pouvant être commandé, qui contient une première combinaison RC d'intégration (RT1/CT1) et une seconde combinaison RC d'intégration (RT2/CT2), un élément de combinaison logique (3) pourvu de deux entrées et d'une sortie, un commutateur d'initialisation (5) et une unité de commande (4), dans lequel la première entrée de l'élément de combinaison logique (3) obtient un signal d'horloge, et sa seconde entrée reçoit un signal de réglage analogique (SSE) en provenance de la sortie du circuit de retardement (2), dans lequel un signal d'horloge est généré et délivré à l'élément de combinaison logique (3) sur deux trajets de signal différents (T1, T2), dans lequel le premier trajet de signal (T1) ne retarde pas notablement le signal d'horloge, et le second trajet de signal (T2) contient le circuit de retardement (2), le signal d'horloge (T1) est délivré à la première entrée de l'élément de combinaison logique (3), et le signal d'horloge (T2) retardé par le second trajet de signal est délivré à la seconde entrée de l'élément de combinaison logique (3), dans lequel la sortie du circuit de retardement (2) est déchargée ou chargée par le commutateur d'initialisation (5) après chaque impulsion de mesure, **caractérisé en ce que** le circuit de retardement (2) obtient une tension de polarisation variable à la sortie (SSE) du circuit de retardement au moyen d'un signal de précharge variable (VL), de sorte que l'instant de passage sous un seuil de commutation de l'élément de combinaison logique varie, et que des impulsions de sortie variables dans le temps sont générées à l'aide de signaux de précharge variables dans le temps (VL).

2. Générateur d'impulsions (1) pour la mise en œuvre du procédé selon la revendication 1.

3. Générateur d'impulsions (1) selon la revendication 2, **caractérisé en ce que** la constante de temps de la première combinaison RC d'intégration (RT1/CT1) se situe dans la plage de temps comprise entre 10 ns et 200 ns, et **en ce que** la constante de temps de la seconde combinaison RC d'intégration (RT2/CT2) présente une valeur supérieure à 1 µs.

4. Utilisation d'un générateur d'impulsions (1) selon la revendication 2 ou 3 dans un capteur capacitif, dans laquelle l'unité de commande (4) sert à évaluer les signaux de mesure et à émettre un signal de commutation binaire et/ou un signal de diagnostic.

5. Utilisation d'un générateur d'impulsions (1) selon la revendication 2 ou 3 dans un capteur capacitif, dans laquelle l'unité de commande (4) sert à évaluer les signaux de mesure et à émettre un signal de commutation binaire et/ou un signal de diagnostic par le biais d'une interface de bus (6).

6. Utilisation d'un générateur d'impulsions 1 selon la revendication 2 ou 3 pour un capteur capacitif dans un véhicule automobile, par exemple pour un dispositif d'ouverture de porte ou un hayon de coffre.
